# EUROPEAN PATENT APPLICATION

(11) **EP 1 296 378 A1**
(43) Date of publication of application: **26.03.2003**
(21) Application number: 01830599.5
(22) Date of filing: 21.09.2001
(51) Int. Cl.: H01L 29/78, H01L 29/423, H01L 29/10, H01L 29/08, H01L 23/485, H01L 21/336

(54) **MOS semiconductor device and manufacturing process thereof**

(71) Applicant: STMicroelectronics S.r.l., 20041 Agrate Brianza (Milano) (IT)
(72) Inventor: Schillaci, Antonino, 98125 Messina (IT); Ponzio, Paola Maria, 93012 Gela (CL) (IT)
(74) Representative: Mittler, Enrico

(57) **Abstract**

A MOS technology semiconductor device formed on a substrate (1) of a first conductivity type is described. The device comprises zones (200) where elementary active units suitable for treating electric signals and at least one inactive zone (100, 101) suitable to the electric signal output or input are formed. The substrate (1) is connected with the drain terminal of said device and the elementary active units comprise body regions (23) of a second conductivity type which are connected with to the source terminal. The at least one inactive zone (100, 101) comprises a semiconductor region (4) of a second conductivity type which is formed in the substrate (1), which is adjacent with a surface of the substrate, which is connected with the source terminal of the device and placed under a conductive layer (7); the semiconductor region (4) is covered by a silicon oxide layer (2) which has a surface alternation of first (8) and second (5) zones which are contiguous to each other and wherein the first zones (8) have a higher thickness than the second zones (5) and the silicon oxide layer (2) is covered by a conductive layer (7).

## Description

The present invention relates to a high efficiency MOS technology semiconductor device and to a manufacturing process thereof, particularly to a radio frequency device.

In electronic devices, as those in radio frequency, the signals must be treated preventing alteration of the same inside the device. Therefore in said devices all the factors that can bring to a perturbation of the signal waveform or which can add noise to the signal must be minimized. Such factors, in the radio frequency devices, must be researched in the presence of the parasitic capacitances and in problems linked to the main physic-structural parameters, as the problem related to the power dissipation of the MOS technology device in stationary state which is linked to the resistance of the device in on state. Thereby there is the exigency of researching structural solutions allowing to reach both an optimisation of such physic-structural parameters and a parasitic capacitance reduction.

The parasitic capacitance reduction of the MOS technology semiconductor devices is linked to the use of prefixed thickness of the field or gate oxide layers and of the dielectric layers.

Such devices comprise active zones for treating the radio frequency signal and other electric signals which are necessary for the device's operation and inactive zones assigned, for example, to the output and the input of the electric signals, as the so-called "gate-bus" and "gate-pad". In such inactive zones the main parasitic capacitance which must be reduced is represented by the gate-drain capacitance.

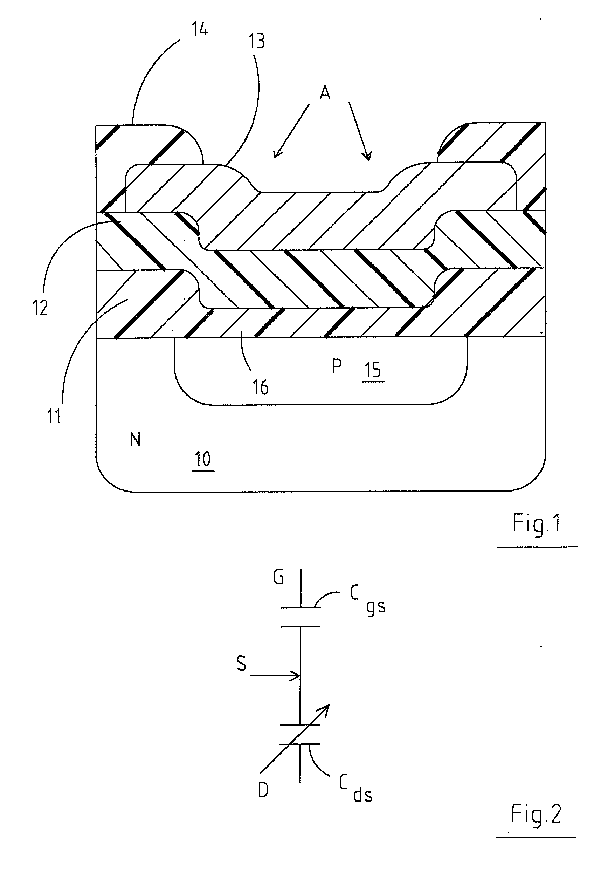

It is known in the state of the art the possibility of reducing such capacitance by performing shield regions (this is semiconductor regions doped with P-type dopant in the case of a n-channel MOS device) connected with the source terminal of the device, as shown in Figure 1. In such Figure a final structure of a shielded pad is described wherein a thick silicon oxide layer 11 (said even field oxide), a dielectric layer 12, a metal layer 13, and a passivation layer 14 only in the periphery parts of the structure are respectively placed over a N type epitaxial layer 10 which constitutes the drain of the device and which is placed over a N type substrate which is not shown. In a central part A of the structure of Figure 1, which constitutes the pad, the field oxide layer 11 has a lower thickness than in the periphery parts; this is due to the fact that, in said central part A, before the deposition of the dielectric layer 12, the field oxide layer 11 is attached and removed for providing a N type dopant implant (typically it is used the same implant that allows to form a P type semiconductor ring in the edge structure of the device); successively a thin silicon oxide layer 16 is formed in the central part A. After a P type dopant diffusion, a P type semiconductor well is formed inside the N type epitaxial layer and under the oxide layer of said central part, and the well is connected with the source terminal of the device. In such way, as shown in Figure 2, the gate-drain capacitance Cgd is divided in a series of a gate-source capacitance Cgs due to the oxide layer with drain-source differential capacitance Cds that changes according to the values of the potentials of the source and drain terminals. The capacitance Cgd changes essentially with the differential capacitance Cds when the source-drain voltage is not zero, while it depends principally on the capacitance Cgs when the source-drain voltage is zero. Since the capacitance Cgs is inversely proportional to the silicon oxide layer thickness, such capacitance will have a high value.

In view of the state of the art described, it is an object of the present invention to provide a high efficiency MOS technology semiconductor device and a manufacturing process thereof which is innovative with respect to those known.

According to present invention, such object is obtained by means of a MOS technology semiconductor device formed on a substrate of a first conductivity type, said device comprising zones where elementary active units suitable for treating electric signals and at least one inactive zone suitable to the electric signal output or input are formed, said substrate being connected with the drain terminal of said device and said elementary active units comprising body regions of a second conductivity type which are connected with to the source terminal, said at least one inactive zone comprising a semiconductor region of a second conductivity type which is formed in said substrate, which is adjacent with a surface of the substrate, which is connected with the source terminal of the device and placed under a conductive layer, characterized in that a silicon oxide layer is placed between said semiconductor region and said conductive layer, which has a surface alternation of first and second zones which are contiguous to each other and wherein said first zones have a higher thickness than said second zones.

According to present invention it is even possible to provide a process for manufacturing a MOS technology semiconductor device comprising a sequence of steps to form elementary active units in active zones of said device, said step sequence comprising a step of masking and of successive implant and diffusion of dopant of a first conductivity type in a semiconductor substrate of a second conductivity type for forming body regions of said elementary active units, said process comprising a step to form a field oxide layer on the substrate in inactive zones of said device, characterized by comprising a step of masking and of selective attack of said field oxide layer in said inactive zones for removing said field oxide layer only in at least two selected parts, a step of implant of dopant of the first conductivity type on the semiconductor substrate of the second conductivity type in said inactive zones in order to form semiconductor regions of the first conductivity type under said at least two selected parts of the field oxide layer, a step of thermal diffusion of the dopant in said substrate of the inactive zones in order to merge together the adjacent regions of the first conductivity type before formed and simultaneously to form silicon oxide in said at least two selected parts in order to obtain a silicon oxide layer having a surface alternation of at least two first and second zones which are contiguous between them and wherein said first zones have a higher thickness than said second zones, a step of deposition of a conductivity layer over said silicon oxide layer.

Thanks to present invention it is possible to form a high efficiency MOS technology semiconductor device that has a lower gate-drain capacitance in the inactive zones of gate-pad or of gate-pad.

The features and the advantages of the present invention will be made evident by the following detailed description of an embodiment thereof, shown as not limiting example in the annexed drawings, wherein:
Figure 1 is cross-sectional view of a gate-pad of a MOS technology semiconductor device according to the prior art;
Figure 2 is a scheme of the capacitance Cgd of the gate-pad of Figure 1;
Figure 3 is a cross-sectional view of an inactive zone of a semiconductor device according to the present invention;
Figures 4-7 represent sections of active regions of the semiconductor device according to some steps of the process according to present invention;
Figure 8 is a layout of a part of the device according to invention in formation step;
Figure 9 is a diagram of the capacitance Cgd of the device according to invention and of a known device in function of the supply voltage;
Figure 10 is a diagram of the Rdson and of the breakdown voltage BV of the device according to invention and of a device deprived of N+ enrichment regions;
Figure 11 is a diagram of power gain Pg of the device in function of the output power Pout.

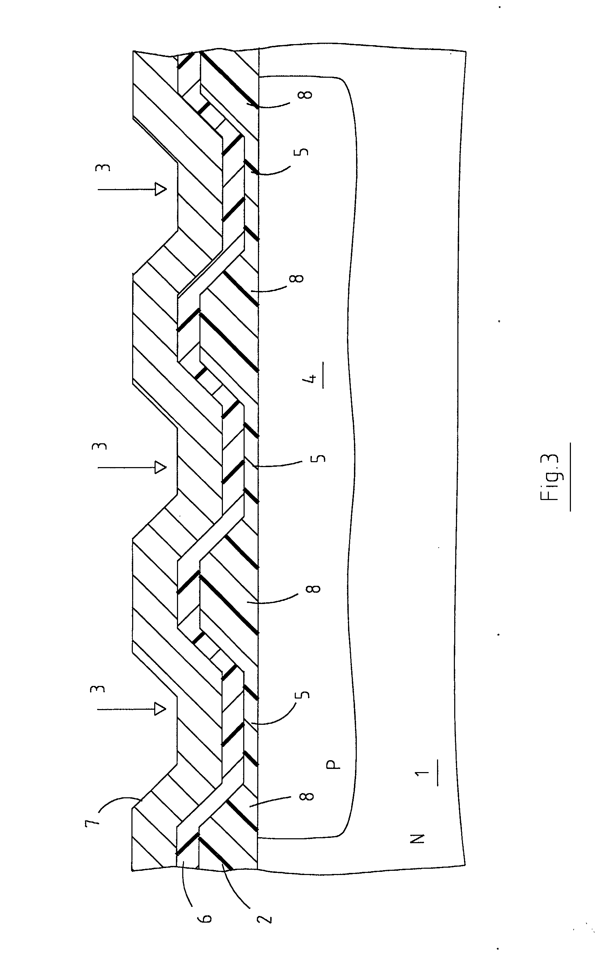

Referring to Figure 3 an inactive zone of the MOS technology semiconductor device according to invention is shown. Such inactive zone, destined to become a gate-pad or a gate-bus for the output or the input of the signals, comprises an N type semiconductor substrate comprising in turn an N type epitaxial layer 1 which is connected to the drain terminal: A deposition of a field oxide layer 2 (for example with a thickness of 10Kangstrom) occurs over a top surface of the layer 1, which successively, after appropriate masking, is attached and removed in certain zones 3. Under the lasts P type semiconductor wells are formed by means of a P type dopant implant and, after a further thermal diffusion step allowing to merge said wells, one P type region 4 is formed which is connected with the source terminal of the device. Such P type dopant implant and diffusion is obtained by using the same P type dopant implant and diffusion steps which are necessary to form the body regions in the active zones of the device. The surface cover of the zones 3 with thin silicon oxide layers 5, which have been formed simultaneously with the dopant diffusion because of the field oxide diffusion, allows to form a silicon oxide layer having thick zones 8 and thin zones 5 which are alternated with and contiguous to each other. The silicon oxide layer is preferably covered by a dielectric layer 6; a metal layer 7 is placed over the dielectric layer 6 in order to form the pad or the bus.

In such way, as shown in Figure 3, the gate-drain capacitance Cgd is divided in the series of a gate-source capacitance Cgs due to the oxide layer and of a drain-source differential capacitance Cds that changes according to the values of the potentials of the source and drain terminals. The capacitance Cgd changes essentially with the differential capacitance Cds when the source-drain voltage is not zero, while it depends principally on the capacitance Cgs when the source-drain voltage is zero. The semiconductor region 4 acts as a shield between the layer 1 connected with the drain terminal and the silicon oxide layer 2.

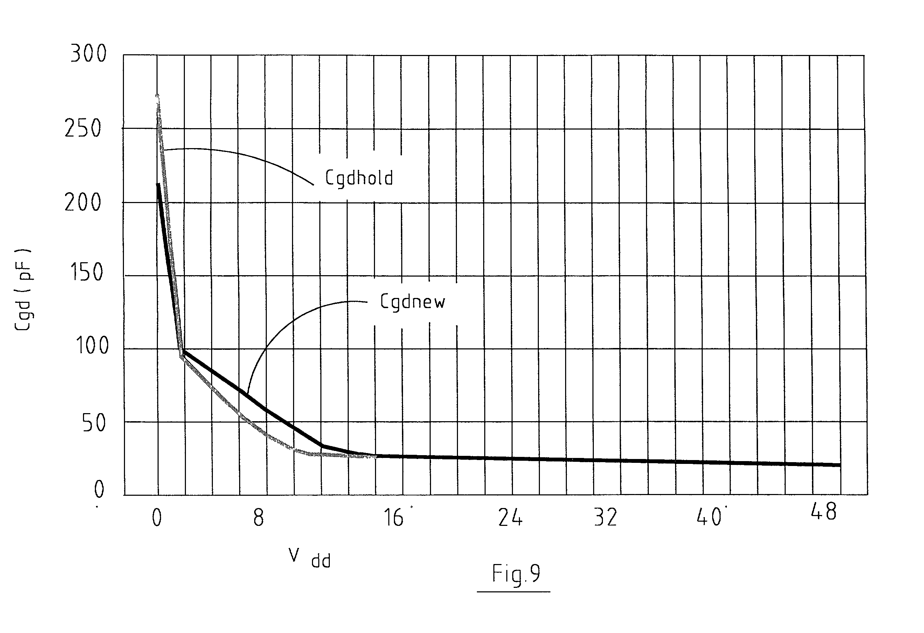

The structure shown in Figure 3 allows to obtain a good compromise between a not excessively high capacitance Cgd at 0Volt and a very low capacitance Cgd at 50Volt. In Figure 9 a graphic of the values of the capacitance Cgd in function of the voltage between source and drain, which in this case is equal to the supply voltage Vdd, for the inactive zone according to invention, which is indicated by Cgdnew, and for the pad of Figure 1 (prior art), which is indicated by Cgdhold, is shown. It is possible to see that the capacitance Cgdnew assumes lower values than those of the capacitance Cgdhold with Vdd values equal to zero or next the zero, while with high Vdd values the capacitance Cgdnew is low.

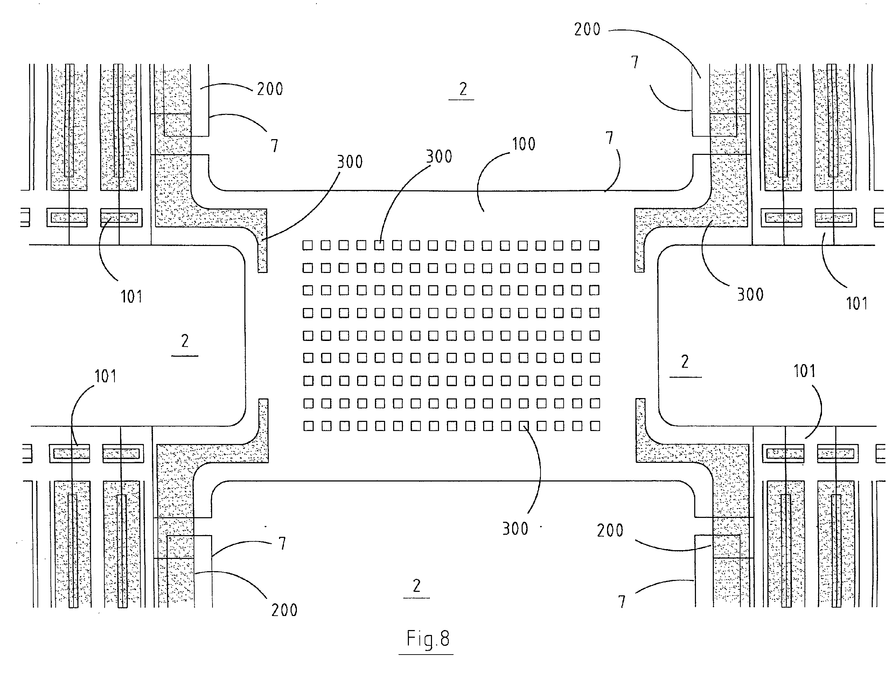

In the structure shown, the implant of the P region can be perform without totally removing the oxide and by using an appropriate masking 300 shown in Figure 8 where a layout of a part of the device according to invention is shown wherein a gate-pad zone 100, a gate-bus zones 101 and active zones 200 are shown. The gate bus zones 101 are allocated on the periphery of the active zones 200 and allow to carry the signal from the pad 100 into the active zones 200; the formation of the such gate-bus inactive zones 101 is totally similar to the formation of the gate-pad inactive zones 100 even if the masking parts 300 are greater than the masking parts 300 utilized for the gate-pad 100 in order to obtain greater P type semiconductor regions after the dopant implant. The layout of Figure 8 is not the final layout of the device according to invention but it is a layout of the device in formation step and it comprises the masking 300 for removing the field oxide 2, the field oxide 2 and the first metal layer 7.

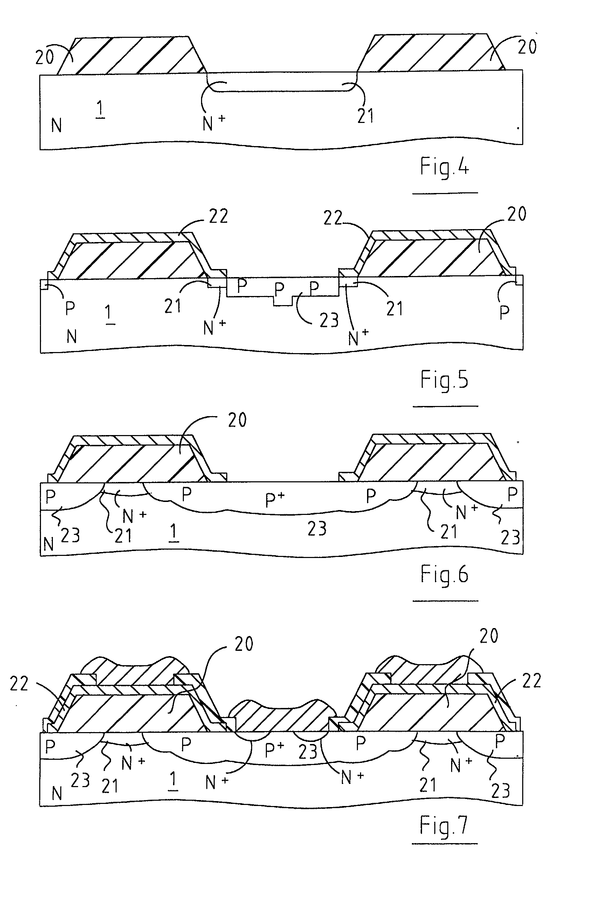

For improving the radio frequency characteristics of the device according to invention, it is possible to provide, during the manufacturing process of said device, steps for forming regions which have the-same conductivity of the substrate but which are enriched with dopant in the active zones of the device; in the case of a n-channel MOS device N+ type semiconductor regions, called N+ enrichment regions, are obtained. In Figure 4 an active zone of the device according to invention is partially shown wherein a N+ type dopant implant (with doping, for example, of the order of 10¹²atoms/cm³) occurs over a central part of the N type substrate 1 which is comprised between two field oxide 20 with consequent formation of a N+ type semiconductor well 21. After a successive masking a deposition of polysilicon 22 and successive P and P+ type dopant implant and appropriate masking for forming a body region 23 occur (Figure 5). In this way two small regions of the previous semiconductor well 21 remain which are allocated under wings 24 of the polysilicon layer 22 which protrude with respect to the field oxide zones and which have protected such regions from the P type dopant implant. The lateral thermal diffusion step allows the N+ type dopant of the regions 21, which is remained under the polysilicon wings 24, to move under the field oxide zones 20 (Figure 6). In Figure 7 the final structure of the device active zone so obtained is shown.

The N+ type semiconductor zones under the field oxide zones allow to improve the Rdson of the device and prevent reduction of the breakdown voltage value that the device can withstand because such zones are formed for lateral diffusion and not for N+ direct implant.

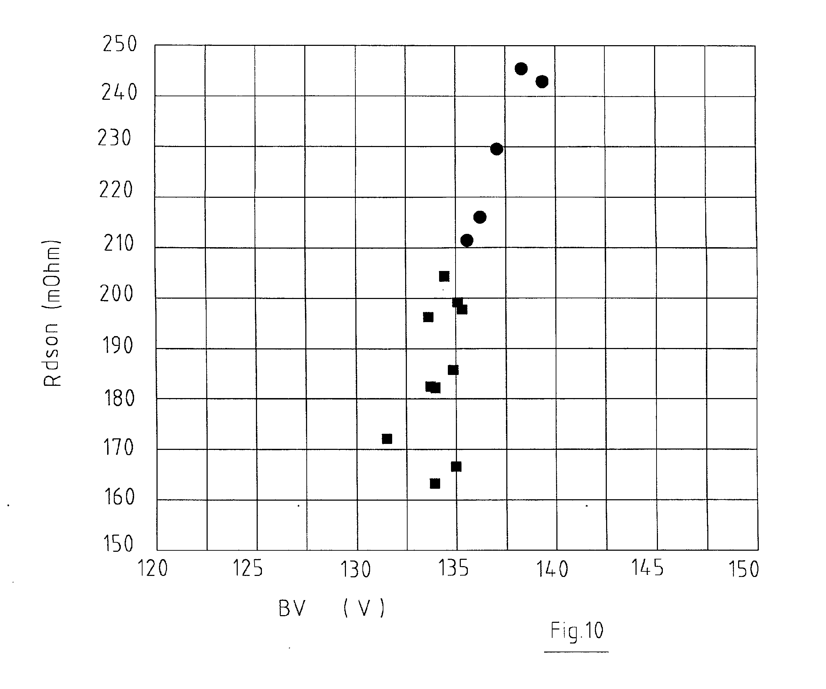

In Figure 10 the diagram of the Rdson and of the breakdown voltage BV of a known device deprived of N+ enrichment regions (indicated graphically by small square) and of the device according to invention (indicated graphically by small balls) can be seen.

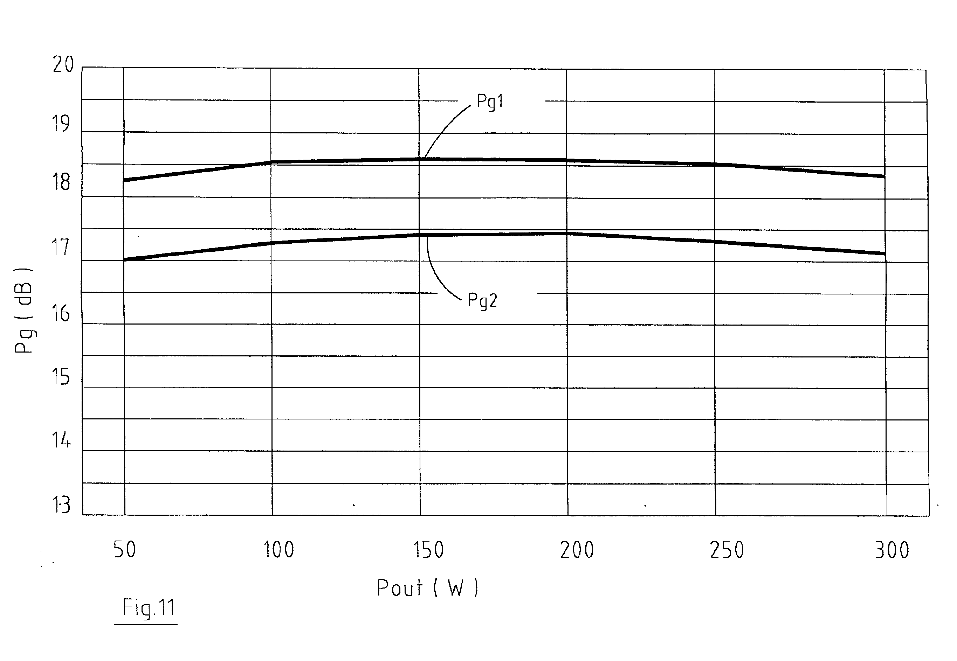

In Figure 11 a diagram of power gain Pg (in decibel) in function of the output power Pout of the device according to invention (PG1) and for a known device (PG2) can be seen.

## Claims

1. MOS technology semiconductor device formed on a substrate (1) of a first conductivity type, said device comprising zones (200) where elementary active units suitable for treating electric signals and at least one inactive zone (100, 101) suitable to the electric signal output or input are formed, said substrate (1) being connected with the drain terminal of said device and said elementary active units comprising body regions (23) of a second conductivity type which are connected with to the source terminal, said at least one inactive zone (100, 101) comprising a semiconductor region (4) of a second conductivity type which is formed in said substrate (1), which is adjacent with a surface of the substrate, which is connected with the source terminal of the device and placed under a conductive layer (7), **characterized in that** a silicon oxide layer (2) is placed between said semiconductor region (4) and said conductive layer (7), which has a surface alternation of first (8) and second (5) zones which are contiguous to each other and wherein said first zones (8) have a higher thickness than said second zones (5).

2. Device according to claim 1, **characterized in that** said substrate (1) comprises an epitaxial layer (1) of the first conductivity type.

3. Device according to claim 1, **characterized in that** a dielectric layer (6) is placed between said silicon oxide layer (2) and said conductive layer (7).

4. Device according to claim 1, **characterized in that** first heavily doped semiconductor regions (21) of the first conductivity type are placed in said active zones (200) of the device between said body regions (23) of the second conductivity type and adjacent and under field oxide zones (20), said field oxide zones (20) being placed under a polysilicon layer (22) and said body regions (23) comprising second heavily doped semiconductor regions of the first conductivity type, said body regions (23) and said second semiconductor regions of the first conductivity type being placed under a metal layer.

5. Device according to claims 1 or 2, **characterized in that** said first and second conductivity types are respectively P and N types.

6. Device according to claims 1 or 2, **characterized in that** said first and second conductivity types are respectively N and P types.

7. Process for manufacturing a MOS technology semiconductor device comprising a sequence of steps to form elementary active units in active zones (200) of said device, said step sequence comprising a step of masking and of successive implant and diffusion of dopant of a first conductivity type in a semiconductor substrate (1) of a second conductivity type for forming body regions (23) of said elementary active units, said process comprising a step to form a field oxide layer (2) on the substrate (1) in inactive zones (100, 101) of said device, **characterized by** comprising a step of masking and of selective attack of said field oxide layer (2) in said inactive zones (100, 101) for removing said field oxide layer (2) only in at least two selected parts (3), a step of implant of dopant of the first conductivity type on the semiconductor substrate (1) of the second conductivity type in said inactive zones (100, 101) in order to form semiconductor regions of the first conductivity type under said at least two selected parts (3) of the field oxide layer (2), a step of thermal diffusion of the dopant in said substrate (1) of the inactive zones (100, 101) in order to merge together the adjacent regions of the first conductivity type before formed and simultaneously to form silicon oxide (5) in said at least two selected parts (3) in order to obtain a silicon oxide layer (2) having a surface alternation of at least two first (8) and second (5) zones which are contiguous between them and wherein said first zones (8) have a higher thickness than said second zones (5), a step of deposition of a conductivity layer (7) over said silicon oxide layer (2).

8. Process according to claim 7, **characterized in that** said steps of masking, implant and diffusion in the inactive zones (100, 101) occur during said step of masking, implant and diffusion of dopant of the first conductivity type to form the body regions (23) of the elementary active units.

9. Process according to claim 7, **characterized in that** said body regions (23) are formed in semiconductor zones comprised between field oxide zones (20), and **in that** in said zones before the dopant implant step for forming the body regions (23) a step of implant of dopant of the second conductivity type occurs to form heavily doped regions of the second conductivity type between said field oxide zones (20), a step of deposition of polysilicon (22) over said field oxide zones (20) and in part over said regions (21) of the second conductivity type so that after the step of masking and of dopant implant to form the body regions (23) heavily doped regions (21) of the second conductivity type remain at the sides of the implanted body regions, and simultaneously to the step of lateral diffusion of the implanted dopant to form the body regions (23) a step of lateral diffusion to form heavily doped regions (21) of the second conductivity type which are comprised between said body regions (23) and under and adjacent to said field oxide zones (20).

10. Process according to claim 7, **characterized in that** said substrate (1) comprises an epitaxial layer (1) of the first conductivity type.

11. Process according to claim 7, **characterized in that** before the step of deposition of the conductivity layer (7) a step of deposition of a dielectric layer (6) occurs over said silicon oxide layer (2).

12. Process according to anyone of the claims from 7 to 10, **characterized in that** said first and second conductivity types are respectively N and P types.

13. Process according to anyone of the claims from 7 to 10, **characterized in that** said first and second conductivity types are respectively P and N types.
